(19) Europäisches Patentamt
European Patent Office
Office européen des brevets

(11) Publication number: **0 108 446**
**A2**

# (12) EUROPEAN PATENT APPLICATION

(21) Application number: 83201543.2

(22) Date of filing: 27.10.83

(51) Int. Cl.³: G 11 C 11/40

(30) Priority: 01.11.82 US 438072

(43) Date of publication of application: 16.05.84 Bulletin 84/20

(84) Designated Contracting States: DE FR GB NL

(71) Applicant: MOTOROLA, INC.
1303 East Algonquin Road
Schaumburg, Illinois 60196(US)

(72) Inventor: Mastroianni, Sal
2929 South Estrella Circle
Mesa Arizona 85202(US)

(72) Inventor: Casteel, Carroll
2301 East Harmony
Mesa Arizona 85204(US)

(74) Representative: Ibbotson, Harold
Motorola Ltd Jays Close Viables Industrial Estate
Basingstoke Hants RG22 4PD(GB)

## (54) Polysilicon - diode - loaded memory cell.

(57) A memory cell for storing information having reduced chip area consumption is provided. A pair of latchable cross-coupled multi-emitter NPN transistors (10, 12) has a first emitter (14, 22) connected to a standby current drain (16), and a second emitter (18, 24) coupled to a first bit line (20) and a second bit line (26), respectively. The base of each transistor is cross coupled to the collector of the other transistor. Each of the collectors are further coupled to a row select line by a diode (28, 30) formed in polysilicon. The diodes have a slope factor of approximately two, thereby providing ample differential voltage without the presence of the typical resistors in parallel.

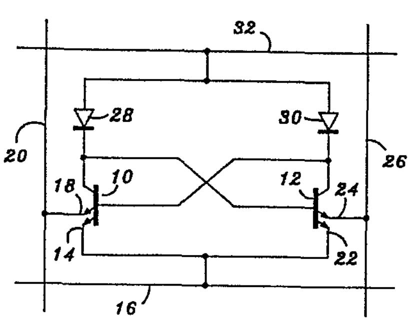


FIG. 1

EP 0 108 446 A2

Croydon Printing Company Ltd.

# POLYSILICON-DIODE-LOADED MEMORY CELL

## BACKGROUND OF THE INVENTION

### FIELD OF THE INVENTION

This invention relates, in general, to bipolar memory cells and more particularly to bipolar memory cells having diodes formed in polysilicon as loads.

### BACKGROUND ART

Memory cells are circuits wherein information may be stored in a low current standby mode and may be written or read in a higher current mode.

Some bipolar memory cells comprise a pair of cross-coupled multi-emitter transistors operating as a latch. The bases of the transistors are cross coupled to each others' collector. A first emitter of each transistor is coupled to a standby current drain line. A second emitter of one transistor is connected to a first bit line and a second emitter of the second transistor is connected to a second bit line. The collectors are further coupled to a row select line by a resistor and Schottky diode in parallel.

This Schottky-clamped resistor load arrangement is used to implement the non-linear resistance required to maintain reasonable cell differential voltage under both the low current stand-by mode and the higher current read/write mode. Cell differential voltage is designed at typically 350 millivolts during stand-by and provides sufficient noise immunity. This differential voltage is usually attained with a large resistor of approximately 30K ohms.

The read/write mode requires an increased current of 30 to 50 times that of the stand-by mode. The Schottky

clamp diode decreases the possibility of the transistors going into heavy saturation. In the stand-by mode, the differential voltage is low enough so that the diode is not turned on. In the read/write mode, the increased current goes through the diode instead of the resistor. Therefore, a higher current exists across the combination cell load elements for only a small increase in differential voltage. Typically, for one decade of additional current, an increase of only about 65 millivolts is obtained once the Schottky clamp diode is turned on.

The large resistors in the memory cells of the known art typically comprise about one third of the cell area and are manufactured using a high resistivity ion implantation. Also, the cells of the known art having bipolar transistors are not operable in a power down mode which draws much less current than the standby mode. Furthermore, the transistors of the known cell can be saturated.

Thus, what is needed is a memory cell that eliminates the requirement for a large load resistor and its associated Schottky clamp diode, thereby reducing the cell layout size, that may be operated in a power down mode, and that will only permit very light saturation of the transistors.

## SUMMARY OF THE INVENTION

Accordingly, it is an object of the present invention to provide an improved memory cell.

In one form of the present invention, there is provided an improved memory cell having a first and a second transistor wherein their bases are cross coupled to each others collector in typical latch fashion. A first emitter of each is connected to a stand-by current drain line. A second emitter of each is connected to a first and second bit line, respectively. The collector of each is coupled to a row select line by first and second diodes formed in polysilicon having a slope factor, or diode ideality factor, of approximately two.

One memory call in accordance with the invention will now be described, by way of example only, with reference to the accompanying drawings in which:

## BRIEF DESCRIPTION OF THE DRAWING

FIG. 1 is a schematic of the preferred embodiment of the invention;

FIG. 2 is a graph illustrating characteristics of the diodes used in the present invention; and

FIG. 3 is a cross section of the semiconductor die of the diodes used in the present invention.

## DETAILED DESCRIPTION OF THE INVENTION

Referring to FIG. 1, a memory cell in accordance with the present invention is shown which is suitable to be

fabricated in monolithic integrated circuit form as well as with discrete components. Emitter 14 of multi-emitter NPN transistor 10 is connected to stand-by current drain line 16. Emitter 18 of transistor 10 is connected to bit line 20. Emitter 22 of multi-emitter transistor 12 is connected to stand-by current drain line 16 and emitter 24 of transistor 12 is connected to bit line 26. The base of transistor 10 is connected to the collector of transistor 12 and the base of transistor 12 is connected to the collector of transistor 10 in typical cross-coupled format. The collectors of transistors 10 and 12 are further connected to the cathodes of diodes 28 and 30, respectively. The anodes of diodes 28 and 30 are connected to row select line 32.

When a low signal appears on bit line 20 and a high signal appears on bit line 26, transistor 10 is on and transistor 12 is off due to the respective voltages at their bases. When the low and high signals on the bit lines 20 and 26 are removed, the latched state is maintained by the low current from emitter 14 of transistor 10. When the signals on bit lines 20 and 26 are reversed, i.e. high and low, respectively, transistor 10 is off and transistor 12 is on. When the high and low signals are removed, the latched state is maintained by the low current from emitter 22 of transistor 12.

The memory cell described herein operates, as just described, in the typical latching arrangement as understood by those skilled in the art. However, the previously known circuitry required a large resistor and a clamping diode in parallel therewith for each load device in place of the presently described load diodes 28 and 30. In a stand-by mode, the load resistor was appropriately selected for the low standby current which stored the information. The diodes were effectively shut off. During the read/write mode requiring a higher current, the diodes

were turned on thereby shunting the current from the resistor and preventing the transistors from saturating.

An attempt to replace the resistor-diode parallel combination has heretofore not been successful. Previously, a single conventional integrated silicon diode between the collector and the row select line in a memory cell would not yield sufficient voltage gain in the circuit and therefore render the latch unoperational. It is known to those skilled in the art that such gain is proportional to the ratio of diode slope factor divided by the transistor slope factor. The lack of gain of the circuit was caused by the slope factor, or ideality factor, of the diode being substantially equal to the slope factor of the emitter base junction of the transistor. The term slope factor, or ideality factor, means the deviation in current versus voltage relationship from a classical exponential law relationship. The exponential curves illustrated in FIG. 2 of an ideal diode 34 and a diode 36 formed in polysilicon are determined from the equation as follows:

$$I = I_s \left( \exp \left( \frac{qV}{nkT} \right) -1 \right)$$

where $I$ equals forward current,
$q$ is the electron charge,
$V$ is the applied voltage,
$I_S$ is the reverse saturation current,
$n$ is the slope factor, and
$kT$ is the average thermal energy.

A slope factor of an ideal diode is one. A single Schottky diode coupled between the collector of the transistor and the row select line provides a slope factor ratio of 1.2 and some net gain in the cell. However this net gain and the resulting differential voltage is insufficient for noise immunity.

Recently, diodes formed in polysilicon have been produced which have a slope factor of approximately two. Typically, polysilicon is deposited on an insulator. Junctions are then formed in the polysilicon by ion inplantation or diffusion using conventional process techniques.

A typical diode formed in polysilicon is illustrated in FIG. 3 and includes a silicon substrate 40 having an overlying oxidation layer 42 of silicon dioxide ($SiO_2$). A polysilicon deposited layer 44 overlies the silicon dioxide layer 42. An arsenic implanted N+ region 46 and a masked boron implant P+ region 48 underlies a portion of metal contacts 50, 52, respectively. Oxide grown layer 54 and nitride deposition layer 56 overlies layer 44 and the remaining portion of regions 46, 48.

When these diodes formed in polysilicon are used with transistors 10, 12, a slope factor ratio of approximately two can be achieved. This results in a differential voltage greater than 200 millivolts which produces a stable cell. Furthermore, the differential voltage can be retained over a wide current range so that the cell can still retain data at a very low current for power down operation.

By now it should be appreciated that there has been provided an improved memory cell. This memory cell reduces the chip layout area. Operation over a wide current range is obtained providing for a power down mode.

CLAIMS

1. A memory cell having a first bit line (20), a second bit line (26), a row select line (32), a standby current drain line (16), a pair of latchable cross-coupled transistors (10, 12), each of said transistors having a first emitter (14, 22) coupled to said standby current drain line and a second emitter (18, 24) coupled to said first bit line and said second bit line, respectively, the improvement comprising coupling the collector of each transistor to said row select line by a first diode (28) formed in polysilicon and a second diode (30) formed in polysilicon respectively, said diodes having a slope factor greater than 1.5.

2. A memory cell having a first bit line (20), a second bit line (26), a row select line (32), and a standby current drain line (16), comprising:

a first transistor (10) having a base, collector, a first emitter (18), and a second emitter (14), said first emitter coupled to said first bit line, said second emitter coupled to said standby current drain line;

a second transistor (12) having a base, collector, a first emitter (24), and a second emitter (22), said first emitter coupled to said second bit line, said second emitter coupled to said stand-by current drain line, said base coupled to said collector of said first transistor and said collector coupled to said base of said first transistor;

a first diode (28) having a cathode coupled to said collector of said first transistor and an anode coupled to said row select line; and

a second diode (30) having a cathode coupled to said collector of said second transistor and an anode coupled to said row select line, wherein only said first diode and said second diode are coupled between said

collectors and said row select line, said diodes having slope factors greater than 1.5.

3. The memory cell according to claim 2 wherein said first and second diodes are formed in polysilicon.

4. A latch circuit having at least one input conductor (20) and at least one output conductor (32), comprising:

a first transistor (10) coupled to and responsive to said at least one input terminal;

a second transistor (12) cross coupled to said first transistor;

a first diode (28) having a cathode coupled to said first transistor; and

a second diode (30) having a cathode coupled to said second transistor, said at least one output conductor coupled to said cathode of one of said first and second diodes, wherein only said first diode and said second diode are coupled between said collectors and said row select line, said diodes having slope factors greater than 1.5.

5. The latch circuit according to claim 4 wherein said diodes are formed in polysilicon.

6. A bipolar memory cell having multi-emitter cross-coupled transistors (10, 12) wherein the improvement comprises diodes (28, 30) having slope factors greater than 1.5 used as load devices to provide a memory cell capable of operating over a wide current range.

7. A bipolar memory cell according to claim 6 wherein said diodes are formed in polysilicon.

27 ... 0108446

1/1

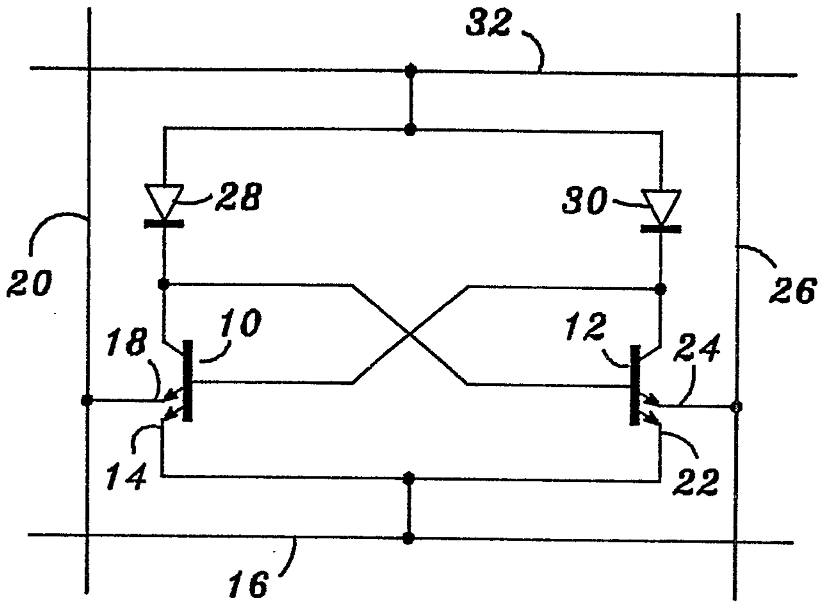


FIG. 1

FIG. 2

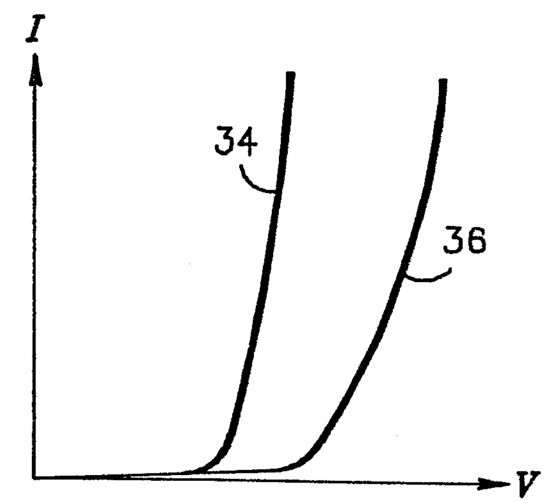


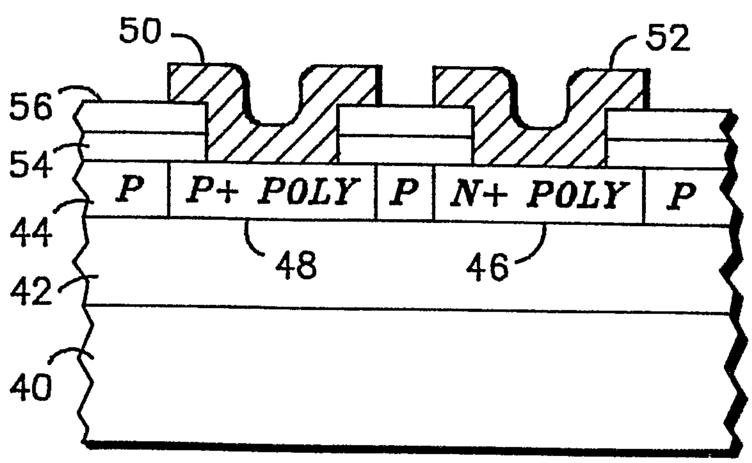


FIG. 3